Europäisches Patentamt

European Patent Office

Office européen des brevets

(19)

(11) EP 0 580 234 B1

(12) **FASCICULE DE BREVET EUROPEEN**

(45) Date de publication et mention
de la délivrance du brevet:
**11.09.1996 Bulletin 1996/37**

(51) Int Cl.⁶: **H03M 9/00**

(21) Numéro de dépôt: **93202096.9**

(22) Date de dépôt: **16.07.1993**

(54) **Convertisseur parallèle-série**

Parallel-Seriell-Umsetzer

Parallel-serial converter

(84) Etats contractants désignés:
**DE GB**

(30) Priorité: **20.07.1992 FR 9208940**

(43) Date de publication de la demande:
**26.01.1994 Bulletin 1994/04**

(73) Titulaire: **FRANCE TELECOM**
**F-75015 Paris (FR)**

(72) Inventeurs:
• **Majos, Jacques**
**F-38420 Le Versoud (FR)**

• **Chemarin, Alain**
**F-38720 St Bernard du Touvet (FR)**

(74) Mandataire: **Martinet & Lapoux**
**BP 405**
**78055 St. Quentin en Yvelines Cédex (FR)**

(56) Documents cités:
**EP-A- 0 006 468**  **EP-A- 0 477 582**
**US-A- 4 015 252**  **US-A- 4 799 040**

**Description**

La présente invention concerne un convertisseur parallèle-série permettant de sérialiser un signal de données déphasé par rapport à un signal d'horloge locale.

Typiquement un convertisseur parallèle-série reçoit dans un bus des données parallèles entrantes d'un équipement de traitement, et reproduit ces données parallèles sous une forme sérialisée dans un support de transmission.

Un tel convertisseur comprend au moins un registre parallèle-parallèle et un registre parallèle-série.

Ces deux registres, constitués à base de bascules logiques, sont agencés en cascade dans le convertisseur. Le registre parallèle-parallèle reçoit les données parallèles entrantes qu'il transfère, au rythme d'un premier signal d'horloge, dans un bus de sortie appliqué à des entrées du registre parallèle-série. Le registre parallèle-série est chargé, au rythme d'un second signal horloge, par ces données transférées qui sont ensuite sérialisées pour être transmises dans le support de transmission.

Selon la technique antérieure, les premier et second signaux d'horloge, ayant une même fréquence, sont indépendants l'un de l'autre en ce qui concerne leur phase. En effet, selon les réalisations conventionnelles, un phaseur est prévu dans le convertisseur pour générer le premier signal d'horloge qui cadence le transfert des données en sortie du registre parallèle-parallèle tandis qu'une base de temps du convertisseur fournit le second signal d'horloge indépendamment du premier signal d'horloge. Le phaseur est utilisé pour générer le premier signal d'horloge avec une phase fonction de la phase des données parallèles entrantes. Les deux registres étant réalisés essentiellement avec des bascules logiques, leur fonctionnement dépend d'instants de transition logique (fronts montants ou descendants) des signaux d'horloge. Il est donc naturel, notamment à des débits élevés, que des instants de transfert des données parallèles entrantes aux sorties du registre parallèle-parallèle coïncident avec des instants de chargement de ces données aux sorties du registre parallèle-parallèle, dans le registre parallèle-série. Dans ce cas précis, le chargement du registre parallèle-parallèle peut entraîner des pertes de données, dues au fait que des instants d'échantillonnage relatifs au chargement des données dans le registre parallèle-série ne correspondent pas avec des durées pendant lesquelles les données sont stables aux sorties du registre parallèle-parallèle.

L'invention vise à remédier aux inconvénients précités en fournissant un convertisseur parallèle-série dans lequel les signaux d'horloge de cadencement du registre parallèle-parallèle et du registre parallèle-série sont dépendants.

A cette fin, selon l'invention, un convertisseur parallèle-série recevant d'un équipement de traitement numérique des mots de données entrantes ayant chacun M bits parallèles pour les convertir en des bits sérialisés transmis à une première fréquence dans un support de transmission, comprend

une base de temps, un registre parallèle-parallèle et un registre parallèle-série,
ladite base de temps recevant un signal d'horloge à ladite première fréquence et produisant un signal d'horloge de chargement à une seconde fréquence M fois inférieure à ladite première fréquence pour cadencer le chargement des mots de données à bits parallèles, préalablement transférés à des sorties du registre parallèle-parallèle, dans le registre parallèle-série, et un premier signal d'horloge à ladite seconde fréquence transmis audit équipement de traitement numérique pour synchroniser celui-ci,
et est caractérisé en ce que
ladite base de temps établit en outre deux seconds signaux d'horloge à ladite seconde fréquence et sensiblement en opposition de phase l'un par rapport à l'autre,
et en ce que ledit convertisseur comprend en outre un moyen d'analyse de phase pour analyser la phase desdits mots de données entrantes à bits parallèles relativement à la phase dudit premier signal d'horloge afin de sélectionner l'un desdits deux seconds signaux d'horloge selon que lesdits mots de données et le premier signal d'horloge sont approximativement en phase et en opposition de phase respectivement, en un signal d'horloge sélectionné qui cadence le transfert des mots de données aux sorties dudit registre parallèle-parallèle.

Selon une réalisation préférée, le moyen d'analyse de phase comprend :

plusieurs moyens de retard connectés en cascade, et imposant des retards dont la somme définit une durée d'analyse de phase prédéterminée, pour retarder l'un prédéterminé de M signaux de bit relatifs aux M bits parallèles dans lesdits mots de données entrantes en plusieurs signaux retardés, respectivement, ladite durée d'analyse étant inférieure à une demi-période desdits signaux d'horloge à la seconde fréquence,
plusieurs moyens d'échantillonnage pour échantillonner ledit premier signal d'horloge en réponse à des transitions logiques prédéterminées dudit signal de bit prédéterminé et desdits signaux retardés afin de produire respectivement plusieurs signaux d'échantillonnage respectivement, et
un moyen logique pour générer en fonction de deux desdits plusieurs signaux d'échantillonnage, un signal de commande dont les états logiques sélectionnent lesdits seconds signaux d'horloge respectivement.

Par ailleurs, afin de remédier à la gigue dans les données entrantes dont les effets affectent particulièrement l'initialisation de fonctionnement du convertisseur, le moyen d'analyse de phase comprend en outre

un moyen pour forcer, lors d'une procédure initiale de fonctionnement dudit convertisseur parallèle-série, le signal de commande en un signal forcé à un état donné sélectionnant l'un desdits deux seconds signaux d'horloge, et le signal de bit prédéterminé est reçu à travers un moyen d'initialisation de signal de commande pour initialiser à un état stable définitif, lors de ladite procédure initiale, ledit signal de commande forcé indépendamment d'une quelconque gigue de phase dans les mots de données entrantes inférieure à une gigue de phase maximale. De préférence, la gigue de phase maximale est sensiblement égale à la différence entre la demi-période desdits signaux d'horloge à la seconde fréquence et ladite durée d'analyse de phase.

D'autres caractéristiques et avantages de la présente invention apparaîtront plus clairement à la lecture de la description suivante de deux réalisations préférées en référence aux dessins annexés correspondants dans lesquels :

- la figure 1 montre un bloc-diagramme d'un convertisseur parallèle-série selon la technique antérieure;
- la figure 2 montre un bloc-diagramme d'un dispositif de rephasage inclus dans le convertisseur parallèle-série de la figure 1;
- la figure 3 montre un diagramme temporel de signaux logiques relatifs au fonctionnement du convertisseur parallèle-série selon l'invention;
- la figure 4 est un bloc-diagramme d'un convertisseur parallèle-série selon l'invention;
- la figure 5 est un diagramme temporel d'échantillonnage;
- la figure 6 montre un bloc-diagramme d'une première réalisation d'un circuit d'analyse de phase inclus dans le convertisseur parallèle-série selon l'invention;
- la figure 7 montre un diagramme temporel relatif au choix de l'un de deux "seconds" signaux d'horloge pour commander un transfert de mots de données entrantes aux sorties d'un registre parallèle-parallèle inclus dans le convertisseur parallèle-série selon l'invention;
- la figure 8 montre un diagramme temporel d'un "premier" signal d'horloge, pour présenter des effets dus à la gigue dans des signaux de données entrantes à convertir;
- la figure 9 montre un bloc-diagramme d'une seconde réalisation d'un circuit d'analyse de phase inclus dans le convertisseur parallèle-série selon l'invention et remédiant aux effets de gigue; et
- la figure 10 montre en détail un exemple de circuit de retard à bascules inclus dans le circuit d'analyse de phase.

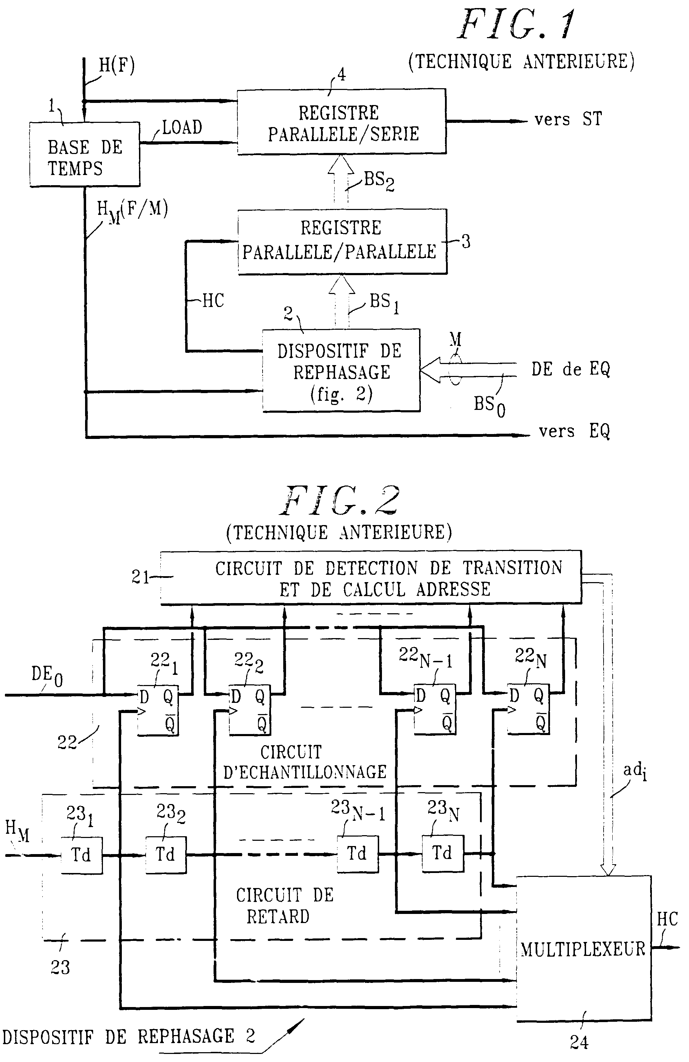

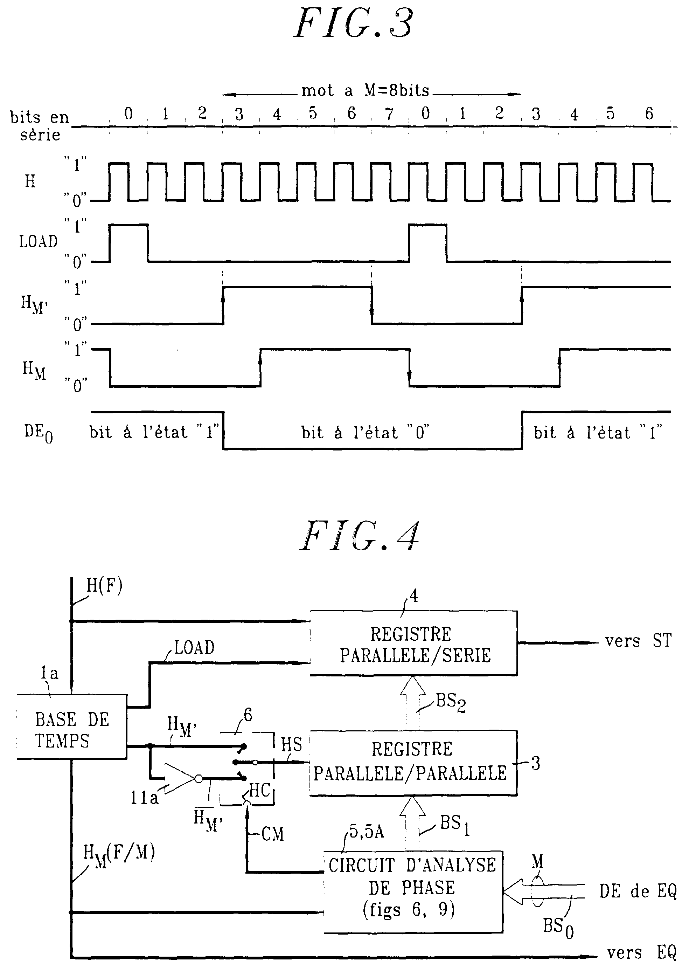

En référence à la figure 1, un convertisseur parallèle-série selon la technique antérieure reçoit des données DE sous forme de mots ayant chacun M bits parallèles, d'un équipement de traitement numérique distant EQ dans un bus d'entrée $BS_O$ à M fils et produit en sortie ces données sous forme sérialisée dans un support de transmission ST. Le convertisseur connu comprend typiquement une base de temps 1, un dispositif de rephasage 2, un registre parallèle-parallèle 3 et un registre parallèle-série 4.

La base de temps 1 reçoit un signal d'horloge de traitement série H à une première fréquence F et produit un signal de chargement LOAD et un signal d'horloge de traitement parallèle $H_M$ à une seconde fréquence F/M, M désignant le nombre de fils du bus d'entrée $BS_O$ du convertisseur parallèle-série. Les signaux H et LOAD sont appliqués à deux entrées respectives du registre parallèle/série 4. Le signal d'horloge $H_M$ est appliqué à une entrée du dispositif de rephasage 2 et est transmis à l'équipement de traitement distant EQ en tant que signal d'horloge de référence. Compte-tenu de ce signal d'horloge de référence $H_M$, l'équipement de traitement distant dispose d'une fréquence (F/M) et d'une phase de référence pour transmettre à ladite fréquence, des mots de données DE à M bits parallèles dans le bus $BS_O$, l'entier M étant typiquement égal à huit. En fonction des mots de données reçus et du signal d'horloge $H_M$, le dispositif 2 produit un signal d'horloge corrigé HC afin d'échantillonner correctement le signal de données. Ce signal HC résulte d'une correction de phase du signal d'horloge $H_M$ qui dépend de la distance séparant l'équipement de traitement distant EQ du convertisseur et introduisant un déphasage des données entrantes DE par rapport au signal d'horloge locale de traitement parallèle $H_M$.

Le signal d'horloge corrigé HC est appliqué à une entrée d'horloge du registre parallèle-parallèle 3 qui reçoit également, à travers un bus de sortie à M fils $BS_1$ du dispositif de rephasage 2, les mots de données entrantes DE. Dans le registre 3, les mots de données DE sont transférés au rythme du signal HC, via un bus de sortie à M fils $BS_2$, à des entrées de données du registre parallèle-série 4. Le signal de chargement LOAD commande le chargement des M bits de chacun des mots de données présent dans le bus $BS_2$ dans M cellules de mémoire tampon du registre parallèle-série 4. Ces bits de mot mémorisés sous forme parallèle dans le registre parallèle-série 4 sont ensuite lus un à un sous la commande du signal d'horloge de traitement série H pour être transmis sous forme sérialisée dans le support de transmission ST. Le signal de chargement LOAD est un signal impulsionnel périodique dont la largeur temporelle des impulsions est égale à une période du signal d'horloge de traitement série H, et dont la période est égale à M périodes de ce signal d'horloge H.

Il apparaît, selon cette réalisation connue, que des fronts montants du signal d'horloge corrigé HC seront positionnés de façon "pseudo-aléatoire" par rapport aux fronts montants des impulsions du signal de chargement LOAD. Par conséquent la stabilité des données lors d'une phase de transfert entre registres 3 et 4 n'est pas garantie, et peut entraîner une perte de données.

Par ailleurs, une gigue de phase peut être a priori présente dans les données entrantes DE. Cette gigue provoque des changements de la phase du signal d'horloge corrigé HC, entraînant des transferts entre registres 3 et 4 à des instants variables imprévisibles qui sont néfastes au fonctionnement du convertisseur.

Le premier inconvénient évoqué ci-dessus résulte d'une indépendance du signal d'horloge corrigé HC par rapport à une quelconque référence temporelle, contrairement au signal de chargement LOAD fourni par la base de temps locale 1. Un glissement de l'une des phases des signaux HC et LOAD par rapport à l'autre est ainsi engendré.

La figure 2 montre en détail une réalisation connue du dispositif de rephasage 2 inclus dans le convertisseur de la figure 1. Le dispositif de rephasage 2, appelé également "phaseur", comprend un circuit de détection de transition et de calcul d'adresse 21, un circuit d'échantillonnage 22, un circuit de retard 23 et un multiplexeur N-vers-1 24.

Le circuit de retard 23 est constitué de N lignes à retard $23_1$ à $23_N$ de retard élémentaire Td, connectées en série. Le signal d'horloge de traitement parallèle $H_M$ produit par la base de temps 1 est appliqué à une entrée de la première ligne à retard $23_1$, et chacune $23_n$ des lignes à retard $23_1$ à $23_N$ reproduit en sortie ce signal d'horloge $H_M$ retardé de (n.Td), avec $1 \leq n \leq N$. Ainsi le signal d'horloge $H_M$ est retardé par des multiples d'un retard élémentaire Td aux sorties respectives des lignes à retard $23_1$ à $23_N$, en une pluralité de signaux d'horloge déphasés. Ces signaux d'horloge déphasés sont appliqués, d'une part, à N entrées du multiplexeur 24 et, d'autre part, à N entrées d'horloge du circuit d'échantillonnage 22, respectivement.

Le circuit d'échantillonnage 22 est constitué de N bascules de type D $22_1$ à $22_N$ recevant chacune par son entrée de données D l'un des bits parallèles des mots de données entrantes DE reçu à travers l'un des M fils du bus $BS_O$, et noté $DE_O$. Aux entrées d'horloge des bascules $22_1$ à $22_N$ sont respectivement appliqués les signaux d'horloge déphasés produits aux sorties des lignes à retard $23_1$ à $23_N$. Des sorties Q des bascules $22_1$ à $22_N$ sont appliquées à des entrées respectives du circuit de détection de transition et de calcul d'adresse 21. Dans les bascules $22_1$ à $22_N$, le bit de données entrantes $DE_O$ est échantillonné respectivement à des instants Td, (2.Td),..., (N.Td) succédant à un front montant du signal $H_M$. Les sorties Q des bascules sont représentatives sous forme discrète de l'état logique, "1" ou "0", du bit de données entrantes $DE_O$ aux différents instants d'échantillonnage successifs respectifs. En choisissant convenablement le retard Td imposé par chacune des lignes à retard $23_1$ à $23_N$, les sorties Q des bascules indiquent la localisation temporelle d'un front montant ou descendant du bit, et plus généralement des transitions dans le signal de données DE. Ainsi par exemple des niveaux "1" et "0" produits respectivement aux sorties des bascules $21_1$ à $21_i$ et $21_{i+1}$ à $21_N$, où i dénote un indice entier quelconque compris entre 1 et N, identifient la localisation d'un front descendant du signal $DE_O$ et donc d'une transition logique pour chacun des bits du signal DE, en correspondance de phase sensiblement avec le front montant du signal d'horloge déphasé produit à la sortie de la ième ligne à retard $23_i$.

En fonction des états des sorties Q des bascules dans le circuit d'échantillonnage 22, le circuit 21 établit une adresse $ad_i$ qui correspond à l'indice de la bascule $21_i$ selon l'exemple ci-dessus. L'adresse $ad_i$ est appliquée à des entrées de sélection ES du multiplexeur 24 afin de sélectionner le signal d'horloge déphasé produit par la ligne à retard $23_i$ parmi les N signaux d'horloge déphasés de manière à produire le signal d'horloge corrigé HC en sortie du multiplexeur 24.

Le diagramme temporel de la figure 3 est relatif au fonctionnement envisagé d'un convertisseur parallèle-série selon l'invention. Dans ce diagramme, il est supposé que les données entrantes parallèles DE dans le bus $BS_O$ sont des mots à M=8 bits parallèles. L'inconvénient principal inhérent au convertisseur parallèle-série selon la technique antérieure présenté ci-dessus réside dans le fait que le signal d'horloge corrigé en phase HC, dont les fronts montants provoquent des transferts de données du bus $BS_1$ vers le bus $BS_2$, est indépendant du signal de chargement LOAD des données du bus $BS_2$ dans le registre parallèle-série 4. Selon l'invention, à la fois le signal de chargement LOAD, représenté sur une troisième ligne de la figure 3, et un signal d'horloge $H_M'$, montré sur une quatrième ligne, sont produits par une même base de temps locale incluse dans le convertisseur. Ce signal d'horloge $H_M'$ de période M/F, égale à une durée de temps-mot des données entrantes DE, offre des fronts montant et descendant sensiblement compris entre deux impulsions du signal de chargement LOAD. En fonction de la phase des données entrantes, est sélectionné, ou bien le signal d'horloge $H_M'$, ou bien le signal complémentaire de celui-ci, noté $\overline{H_M}'$, en un signal d'horloge sélectionné HS qui présente des fronts montants les plus adéquats pour coïncider avec des milieux de temps-mot des données entrantes DE afin que ces dernières soient échantillonnées correctement pour leur transfert dans le bus $BS_2$.

En référence à la figure 4, un convertisseur parallèle-série selon l'invention comprend une base de temps 1a, un inverseur logique 11a, les deux registres parallèle-parallèle et parallèle-série 3 et 4, un circuit d'analyse de phase 5 et un commutateur électronique 6.

La base de temps 1a reçoit un signal d'horloge de traitement série H ayant une fréquence F, et produit un signal de chargement LOAD, qui est appliqué à une entrée de chargement du registre parallèle-série 4, et des premier et second signaux d'horloge de traitement parallèle $H_M$ et $H_M'$. Le premier signal $H_M$ est appliqué à une entrée du circuit d'analyse 5 et est également transmis à un équipement de traitement numérique distant EQ afin que ce dernier transmette à la fréquence du signal $H_M$ des mots de données ayant chacun M bits parallèles dans un bus $BS_O$ connecté à des entrées du circuit 5.

Le second signal d'horloge de traitement parallèle $H_M'$, sensiblement déphasé par rapport au signal $H_M$ pour des raisons explicitées ultérieurement, est appliqué à deux entrées du commutateur 6, respectivement directement et à travers l'inverseur 11a. Le second signal d'horloge de traitement parallèle $H_M'$ et un second signal d'horloge de traitement parallèle complémentaire ou inversé $\overline{H_M}'$ sont ainsi appliqués aux deux entrées respectives du commutateur 6. En fonction du déphasage entre les données parallèles entrantes DE et le premier signal d'horloge de traitement parallèle $H_M$, le circuit d'analyse de phase 5 produit un signal de commande logique CM qui est appliqué à une entrée de commande EC du commutateur 6. En pratique, le commutateur 6 peut être un multiplexeur 2-vers-1. L'état logique du signal de commande CM à un instant donné sélectionne l'un desdits deux seconds signaux d'horloge $H_M'$ et $\overline{H_M}'$ en le signal d'horloge sélectionné HS à appliquer à une entrée d'horloge du registre parallèle-parallèle 3 pour cadencer le transfert des mots de données entrantes DE dans le bus $BS_2$.

En revenant à la figure 3, il apparaît qu'une condition nécessaire au bon fonctionnement du convertisseur parallèle-série selon l'invention consiste en ce que des fronts montants des impulsions du signal de chargement LOAD ayant une largeur égale à une période du signal d'horloge H et délivrées toutes les M périodes du signal d'horloge H doivent succéder chacun de manière sensible à des fronts montant et descendant successifs dans le second signal d'horloge de traitement parallèle $H_M'$, sachant qu'un front descendant du signal $H_M'$ correspond à un front montant du signal complémentaire $\overline{H_M}'$.

Dans les réalisations décrites ci-après du circuit d'analyse de phase 5 inclus dans le convertisseur parallèle-série selon l'invention, l'entier M est supposé égal à 8. Ainsi les données parallèles entrantes DE sont transmises sous forme de mots à 8 bits parallèles dans le bus $BS_O$. Un mot de données entrantes DE s'écrit donc sous la forme d'un octet $(DE_O, DE_1, DE_2, DE_3, DE_4, DE_5, DE_6, DE_7 = DE_{M-1})$.

En référence à la figure 6, le circuit d'analyse de phase 5 comprend un circuit de mémorisation 51, un circuit d'échantillonnage 52, un circuit de retard 53 et un circuit logique de génération de signal de commande 54. Seul, par exemple l'un des bits dans les mots de données entrantes DE, à savoir le bit de poids faible $DE_O$, est utilisé en tant que signal de bit prédéterminé par le circuit d'analyse 5 du convertisseur selon l'invention, bien que n'importe lequel des bits dans un mot de données à M=8 bits parallèles transmis par le bus d'entrée $BS_O$ peut être utilisé puisque tous les bits d'un mot dans les fils respectifs du bus $BS_O$ présentent des phase et débit strictement identiques.

Le circuit de retard 53 est constitué par exemple de trois lignes à retard $53_1$, $53_2$ et $53_3$ en série dont la première reçoit le signal de bit prédéterminé $DE_O$ de chacun des mots de données entrantes DE. Chaque ligne à retard, $53_1$ à $53_3$, retarde d'un retard élémentaire Td prédéterminé le bit qu'elle reçoit. Aux sorties des trois lignes à retard $53_1$ à $53_3$, sont donc obtenus des signaux de bit de poids faible retardés, c'est-à-dire déphasés respectivement par des multiples d'un déphasage élémentaire $(2\pi.Td/T_M)$ où $T_M = M/F$ est la période des mots de données entrantes. Le signal de bit de poids faible $DE_O$ et les signaux déphasés issus des lignes à retard $53_1$ à $53_3$ sont respectivement appliqués aux entrées d'horloge de quatre bascules de type D, $52_1$, $52_2$, $52_3$ et $52_4$ constituant le circuit d'échantillonnage 52.

Les bascules $52_1$ à $52_4$ reçoivent chacune par leur entrée de données D, le premier signal d'horloge $H_M$. Dans ces différentes bascules $52_1$ à $52_4$, le premier signal d'horloge $H_M$ est échantillonné par les signaux déphasés de phases différentes, en réponse à chacun des fronts montants du signal de bit de poids faible non déphasé (non retardé) $DE_O$. Quatre états logiques résultant de l'échantillonnage du premier signal d'horloge $H_M$ en fonction des différentes phases successives sont ainsi fournis respectivement par les sorties Q des quatre bascules $52_1$ à $52_4$ du circuit d'échantillonnage 52. Les sorties Q des quatre bascules $52_1$ à $52_4$ sont appliquées respectivement aux entrées de données D de bascules de type D $51_1$, $51_2$, $51_3$ et $51_4$ dans le circuit de mémorisation 51. L'entrée d'horloge de chaque bascule $51_1$ à $51_4$ reçoit le signal de bit prédéterminé $DE_O$. Ainsi en réponse à un front montant du signal $DE_O$, les états logiques du premier signal d'horloge $H_M$ échantillonnés par les différents signaux déphasés sont stabilisés dans le circuit 51 et reproduits en synchronisme avec le front montant suivant du signal $DE_O$ aux sorties Q des bascules $51_1$ à $51_4$. Les sorties directes Q et inverses $\overline{Q}$ de deux des bascules $51_1$ à $51_4$, savoir des première et dernière bascules $51_1$ et $51_4$ du circuit d'échantillonnage 51 sont reliées à des entrées respectives du circuit de génération du signal de commande 54 qui reçoit également un signal de réinitialisation RESET. Le circuit 54 génère le signal de commande CM en fonction particulièrement de signaux d'échantillonnage $Q_1$, $\overline{Q_1}$, $Q_4$ et $\overline{Q_4}$ aux sorties des bascules $51_1$ et $51_4$ pour commander le commutateur 6 (figure 4) afin de sélectionner, ou bien le second signal d'horloge $H_M'$, ou bien le second signal d'horloge inversé $\overline{H_M}'$.

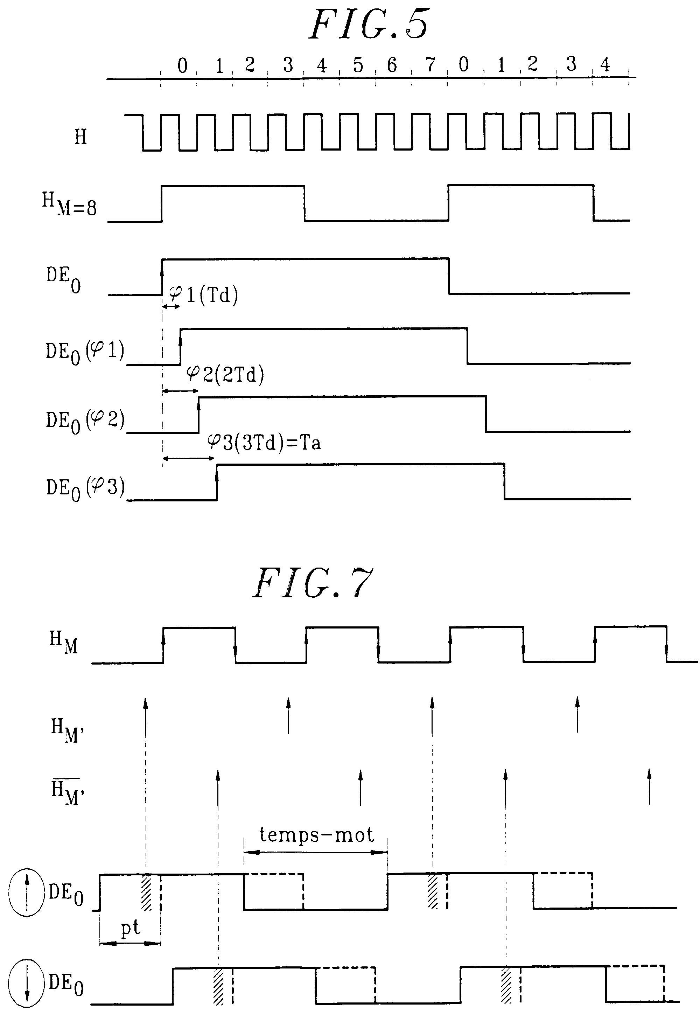

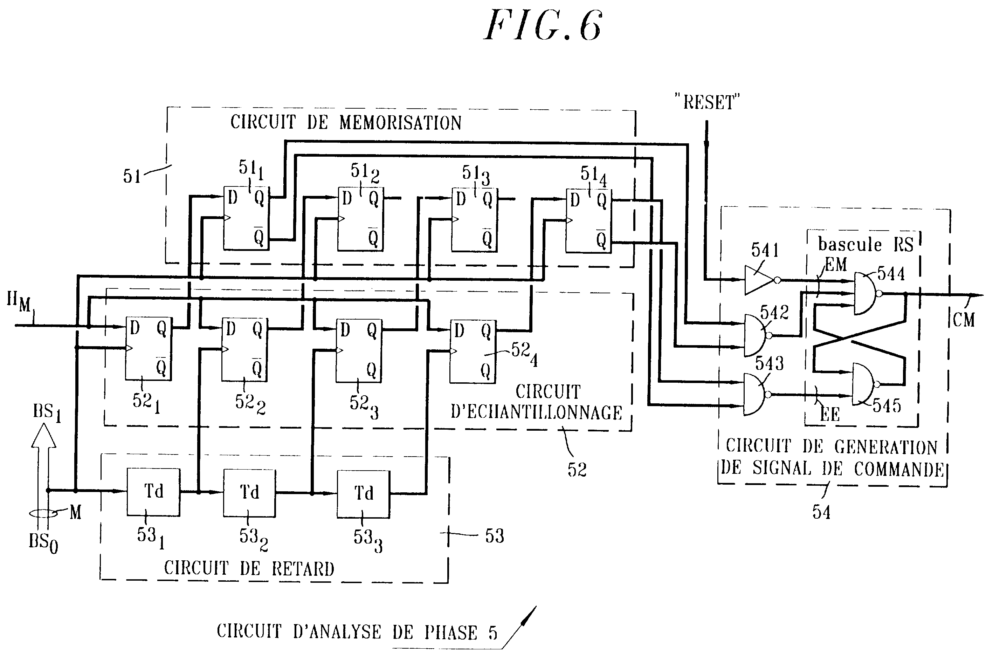

Avant de revenir en détail sur le circuit de génération de signal de commande 54, il est maintenant fait référence aux figures 5 et 7 pour décrire le fonctionnement du circuit d'analyse de phase 5.

Le diagramme temporel montré à la figure 5 concerne la scrutation du signal $H_M$ par le circuit d'échantillonnage 52. Une troisième ligne de ce diagramme temporel montre le premier signal d'horloge $H_M$ qui est appliqué à chacune des entrées de données D des bascules $52_1$ à $52_4$ du circuit d'échantillonnage 52. Des quatrième, cinquième, sixième et septième lignes montrent respectivement le signal de bit de poids faible $DE_O$ des données entrantes et les signaux résultant du déphasage ou retard du signal $DE_O$ aux sorties des trois lignes à retard $53_1$ à $53_3$.

Les fronts montants de chacun de ces signaux constituent des instants d'échantillonnage du premier signal d'horloge $H_M$ dans les bascules $52_1$ à $52_4$. Ces différents instants d'échantillonnage successifs sont contenus dans une durée d'analyse de phase Ta, égale à 3.Td, du premier signal d'horloge $H_M$. Notamment ces différents instants d'échantillonnage du premier signal d'horloge $H_M$ permettent de "repérer" des débuts de temps-mot (fronts montants) des données entrantes relativement à des fronts montants ou descendants du premier signal d'horloge $H_M$ afin de sélectionner soit le second signal d'horloge $H_M'$, soit le second signal d'horloge inversé $\overline{H_M}'$ comme signal d'horloge HS pour transférer les mots de données entrantes DE dans le bus $BS_2$. Le fonctionnement du convertisseur parallèle-série selon l'invention doit satisfaire les deux conditions suivantes :

- d'une part, pour assurer le transfert des données entrantes DE dans le bus $BS_2$, doit être sélectionné celui des deux signaux d'horloge, $H_M'$ et $\overline{H_M}'$, qui présente des fronts montants les mieux centrés dans les durées de temps-mot des données entrantes DE ou, en d'autres termes, les plus éloignés des zones de transition par nature instables des données entrantes au voisinage des débuts et fins de temps-mot ; et
- d'autre part pour prélever et mémoriser des mots de données présents dans le bus $BS_2$, le signal de chargement LOAD du registre parallèle-série 4 doit présenter des fronts montants d'échantillonnage relativement éloignés temporellement des fronts montants des signaux d'horloge $H_M'$ et $\overline{H_M}'$ afin que les mots de données soient stables dans le bus $BS_2$ après leur transfert, octet par octet dans le cas où M = 8, sous la commande du signal d'horloge approprié HS, c'est-à-dire $H_M'$ ou $\overline{H_M}'$.

En se référant à la figure 5 et en considérant en outre la première condition précitée, deux informations peuvent être extraites concernant la durée d'analyse Ta ou, ce qui est équivalent, la somme des retards élémentaires Td imposés par les lignes à retard $53_1$ à $53_3$. Tout d'abord, cette durée d'analyse Ta doit être inférieure à la moitié de la période du premier signal d'horloge $H_M$ afin de détecter au maximum un seul front, montant ou descendant, dans ce signal d'horloge $H_M$, la détection d'un seul front étant suffisante pour "repérer" la phase des mots de données entrantes relativement au signal d'horloge $H_M$. Par ailleurs cette durée d'analyse Ta doit être supérieure à un temps minimal de prépositionnement des mots de données entrantes DE sur les entrées du registre parallèle-parallèle 3. Sans cela, il ne serait pas possible de "repérer" dans une plage de temps suffisamment grande la phase des mots de données entrantes DE relativement au signal d'horloge $H_M$ et ainsi assurer de manière certaine que des débuts de temps-mot des mots de données entrantes DE ne sont pas situés au voisinage de fronts montants de l'un des deux signaux d'horloge $H_M'$ et $\overline{H_M}'$ sélectionné en le signal HS.

Le diagramme temporel de la figure 7 vise à établir une correspondance entre les différents états d'échantillonnage pouvant être produits aux sorties des bascules $51_1$ à $51_4$ du circuit de mémorisation 51 et le signal d'horloge $H_M'$ ou $\overline{H_M}'$ à sélectionner comme signal d'horloge de transfert des mots de données entrantes DE dans le bus $BS_2$.

Il est à noter que l'un $H_M'$ des deux seconds signaux d'horloge est sensiblement en avance de phase par rapport au premier signal d'horloge $H_M$ et l'autre second signal d'horloge $\overline{H_M}'$ est par définition en opposition de phase par rapport au signal $H_M'$. Dans une quatrième ligne de la figure 7 est délimitée une plage temporelle pt dans laquelle peut être localisé temporairement le début de temps-mot des données entrantes DE sachant qu'un front montant du signal $H_M$ est détecté au moyen des bascules $51_1$ à $51_4$ du circuit de mémorisation 51, en tenant compte des limites supérieure et inférieure de la durée d'analyse Ta telles que définies précédemment. Dans le cas d'une détection d'un front montant du signal $H_M$ par échantillonnage au moyen du signal $DE_O$, chacun des mots de données entrantes DE est nécessairement inscrit entre deux phases maximales telles que représentées en trait continu et trait discontinu respectivement sur la quatrième ligne de la figure 7. Il apparaît dans ce cas que le signal d'horloge inversé $\overline{H_M}'$ doit être choisi pour échantillonner les données entrantes DE afin de les transférer dans le bus $BS_2$ aux entrées du registre parallèle-série 4. En effet, comme le montrent des zones minces hachurées sur cette quatrième ligne, si le signal $H_M'$ était sélectionné pour échantillonner les données entrantes DE, des instants d'échantillonnage pourraient sensiblement coïncider avec des débuts de temps-mot des données entrantes DE, une telle coïncidence étant susceptible de causer une perte des données à transférer dans le bus $BS_2$.

Une cinquième ligne dans la figure 7 montre que, dans le cas où un front descendant du signal $H_M$ est détecté lors des échantillonnages successifs par le signal $DE_O$ retardé, le second signal d'horloge $H_M'$ doit être sélectionné pour échantillonner les données parallèles entrantes pour leur transfert dans le bus $BS_2$.

Volontairement, deux cas particuliers n'ont pas été traités ci-dessus savoir les cas où ni le front montant, ni le front descendant du premier signal d'horloge $H_M$ ne sont détectés. Ces cas correspondent au même état logique "1" ou "O" aux sorties Q de toutes les bascules $51_1$ à $51_4$ dans le circuit de mémorisation 51. En revenant à la figure 7 et en maintenant l'hypothèse que la durée d'analyse Ta est strictement supérieure à une durée minimale de prépositionnement de chacun des mots de données entrantes DE et est strictement inférieure à une demi-période du premier signal d'horloge $H_M$, il est étudié ci-après le cas où toutes les bascules de mémorisation $51_1$ à $51_4$ mémorisent un état "1". Une telle mémorisation peut se produire lorsqu'elle succède à une mémorisation antérieure, ou bien des états "0", "1", "1" et "1" ou bien des états "1", "1", "1", "0", dans les bascules $51_1$ à $51_4$, respectivement en fonction du sens du glissement de la phase des données entrantes DE relativement à la phase du signal d'horloge $H_M$.

Si les états "1", "1", "1", et "1" succèdent aux états "0", "1", "1", et "1" aux sorties des bascules $51_1$ à $51_4$, cela signifie en se reportant à la quatrième ligne de la figure 7, que les données entrantes DE sont alors pour ces états "1", "1", "1" et "1" sensiblement en avance de phase par rapport au temps-mot représenté en pointillé et correspondant aux états "0", "1", "1" et "1". Le signal d'horloge $\overline{H_M}'$ est alors maintenu de manière à assurer un bon fonctionnement du convertisseur parallèle-série et à éviter un changement néfaste de la phase du signal d'horloge sélectionné HS ordonnant le transfert des mots de données entrantes aux sorties du registre parallèle-parallèle 3.

Si les états "1", "1", "1" et "1" succèdent aux états "1", "1", "1" et "0" cela signifie en se reportant à la cinquième ligne de la figure 7, que les mots de données entrantes DE sont alors sensiblement en retard de phase par rapport au temps-mot représenté en trait continu sur la cinquième ligne et correspondant à des états "1", "1", "1" et "O". Le second signal d'horloge $H_M'$ est alors maintenu pour échantillonner les données entrantes DE afin de les reproduire aux sorties du registre parallèle-parallèle 3.

Par un raisonnement identique, un résultat similaire est obtenu pour des états "0", "0", "0" et "0" mémorisés aux sorties des bascules $51_1$ à $51_4$ du circuit de mémorisation 51 en maintenant le second signal d'horloge $H_M'$ ou $\overline{H_M}'$ sélectionné précédent.

En conséquence, une table de vérité TV est établie, comme suit :

TABLE TV

| SORTIES Q DES BASCULES | | | | SIGNAL D'HORLOGE SELECTIONNE |
|---|---|---|---|---|
| $51_1$ | $51_2$ | $51_3$ | $51_4$ | |
| 0 | 0 | 0 | 0 | PRECEDENT |
| 0 | 0 | 0 | 1 | $\overline{H_M}'$ (CM = 0) |
| 0 | 0 | 1 | 1 | $\overline{H_M}'$ (CM = 0) |
| 0 | 1 | 1 | 1 | $\overline{H_M}'$ (CM = 0) |
| 1 | 1 | 1 | 1 | PRECEDENT |
| 1 | 1 | 1 | 0 | $H_M'$ (CM = 1) |
| 1 | 1 | 0 | 0 | $H_M'$ (CM = 1) |
| 1 | 0 | 0 | 0 | $H_M'$ (CM = 1) |

Les secondes et troisièmes bascules $52_2$ et $52_3$, $51_2$ et $51_3$, dans les circuits 52 et 51 peuvent en pratique être supprimées, et ne sont illustrées dans la figure 6 (ou 9) que pour la compréhension du fonctionnement du circuit 5.

En référence à nouveau à la figure 6, le circuit de génération de signal de commande 54 est conçu pour générer le signal CM commandant le commutateur 6 de sorte que les sorties des bascules $51_1$ à $51_4$ contribuent en combinaison à sélectionner le second signal d'horloge $H_M'$ ou le second signal d'horloge inversé $\overline{H_M}'$ en sortie du commutateur 6, en correspondance avec la table TV. Comme cela apparaît dans cette table seules les sorties Q et $\overline{Q}$ des première et dernière bascules $51_1$ et $51_4$ dans le circuit de mémorisation 51 sont nécessaires à la génération du signal de commande CM.

Le circuit de génération 54 comprend un inverseur 541, deux portes NON-ET à deux entrées 542 et 543 et une bascule RS à entrées multiples 544. La bascule RS est constituée par une porte NON-ET à trois entrées 544 et une porte NON-ET à deux entrées 545, la sortie de la porte 544 produisant le signal de commande CM. Une double entrée de mémorisation EM de la bascule RS 544 est constituée par deux entrées de la porte 544 qui sont reliées à une entrée du signal de réinitialisation RESET à travers l'inverseur 541 et à la sortie de la porte 542 dont les entrées sont reliées à la sortie Q de la bascule $51_1$ et la sortie complémentaire $\overline{Q}$ de la bascule $51_4$, respectivement. Une entrée d'effacement EE de la bascule RS 544 est constituée par une entrée de la porte 545 qui est reliée à la sortie de la porte 543 dont les entrées sont reliées à la sortie complémentaire $\overline{Q}$ de la bascule $51_1$ et la sortie Q de la bascule $51_4$, respectivement. Le circuit 54 est équivalent à une bascule RS ayant deux entrées d'excitation : une entrée unique de mise à "1" S(set) et une entrée de mise à "O" R (reset) définies par les relations logiques :

$$S = RESET + Q_1 . \overline{Q_4};$$

et

$$R = Q_4 . \overline{Q_1}$$

où $Q_1$ et $Q_4$ désignent respectivement les sorties de données Q des bascules $51_1$ et $51_4$.

Ainsi le signal de sortie de la bascule équivalente RS, c'est-à-dire le signal de commande CM, est à l'état "1" lorsque $Q_1$ est à l'état "1" et $Q_4$ à l'état "O", par la fonction d'excitation S. Inversement le signal CM est à l'état "0" lorsque $Q_1$ est à l'état "O" et $Q_4$ est à l'état "1", par la fonction d'excitation R. Dans le cas où $Q_4$ et $Q_1$ sont tous deux à l'état "1" ou "0" , l'état précédent du signal CM est maintenu conformément au fonctionnement des bascules RS puisque R = S = "0". Le signal RESET est utilisé pour forcer la sortie de la bascule RS 544 et donc le signal CM à un état donné "1" lors d'une phase d'initialisation.

La première réalisation de convertisseur parallèle-série selon l'invention décrite précédemment particulièrement en référence aux figures 6 et 7, est de préférence utilisée lorsque sensiblement la gigue de phase n'est pas susceptible de contrarier le transfert des données entrantes.

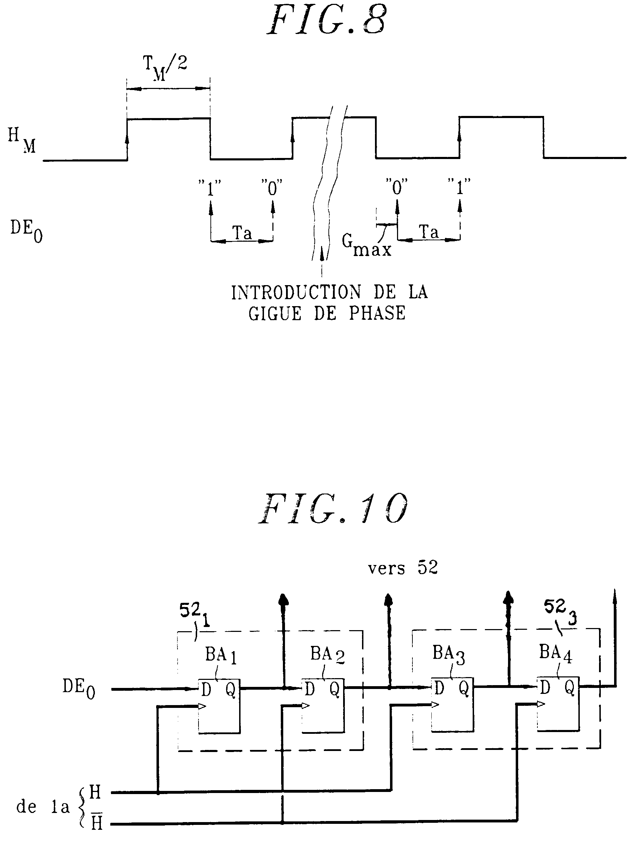

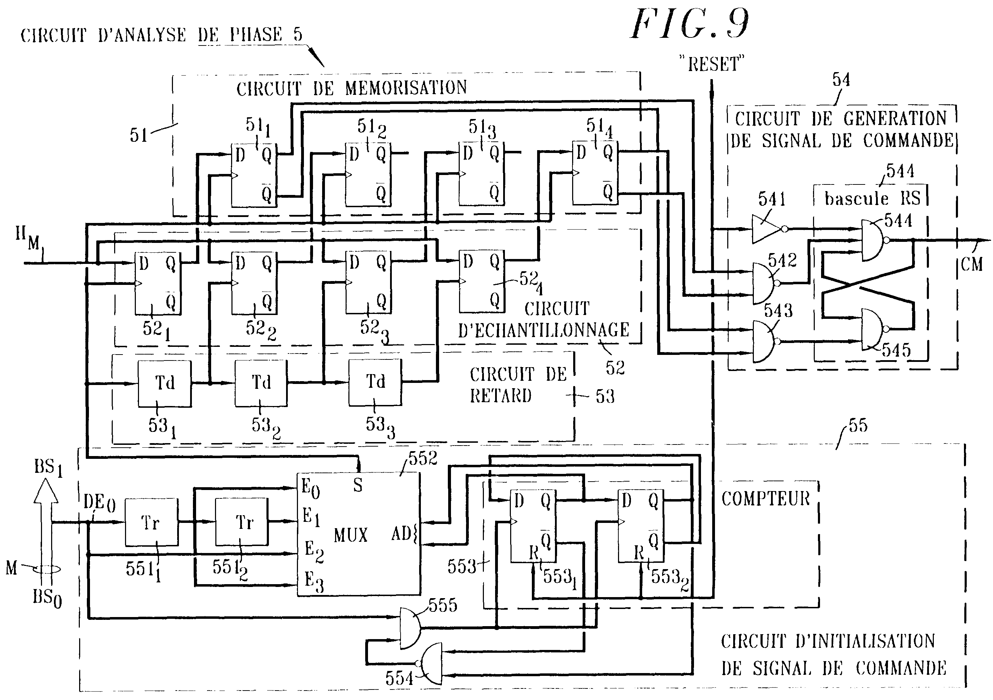

La seconde réalisation de convertisseur parallèle-série selon l'invention décrite ci-après , en référence aux figures 8 et 9, remédie à des effets de gigue de phase.

Comme montré dans la table de vérité TV, il apparaît qu'un changement d'état du signal de commande CM, qui implique la substitution du signal d'horloge $H_M$' au signal $\overline{H_M}$' ou inversement, pour cadencer le transfert des mots de données entrantes DE se produit lorsque les sorties $Q_1$ et $Q_4$ des bascules $51_1$ et $51_4$ du circuit de mémorisation 51 basculent des états "1" et "0" en les états "0" et "1", ou des états "0" et "1" en les états "1" et "0", respectivement.

La figure 8 montre sur une première ligne le premier signal d'horloge $H_M$ , tandis qu'une seconde ligne de cette figure représente, dans un cas extrême, une gigue de phase $G_{max}$ des données entrantes entraînant un saut de phase du signal sélectionné HS cadençant le registre parallèle-parallèle, ou plus précisément un changement de la sélection des deux signaux d'horloge $H_M$ et $\overline{H_M}$'. Une gigue de phase des données entrantes DE prenant une valeur maximale donnée par

$$G_{max} = T_M/2 - Ta,$$

où $T_M$ est la période du signal d'horloge $H_M$ et Ta est la durée d'analyse égale à la somme des trois retards élémentaires Td imposés par les lignes à retard $53_1$, $53_2$, et $53_3$ du circuit de retard 53, entraîne un changement du signal d'horloge sélectionné HS. En accord avec la table de vérité TV, l'exemple illustré à la figure 8 correspond au basculement des sorties $Q_1$ et $Q_4$ des bascules $51_1$ et $51_4$, des états "1" et "0" en les états "0" et "1", et à un changement du signal sélectionné HS de $H_M$' en $\overline{H_M}$'.

Dans la suite, référence est faite à un exemple préféré selon lequel la durée d'analyse Ta est égale à un quart de période du signal d'horloge $H_M$ , soit Ta = $T_M/4$. Dans cet exemple, la valeur de la gigue maximale $G_{max}$ est égale à 12 ns pour une fréquence d'horloge du signal d'horloge de traitement série H égale à 155 MHz et pour des mots de données constitués de M=8 bits, ce qui correspond à une limite supérieure de gigue de phase largement acceptable même pour des conditions extrêmes. La gigue de phase admissible est inférieure à cette gigue de phase $G_{max}$.

Néanmoins, avec une gigue de phase des données entrantes inférieure à $G_{max}$ , et compte-tenu de la condition précitée sur Ta (Ta = $T_M/4$), les sorties Q des bascules $51_1$ à $51_4$ peuvent basculer d'états donnés à des états suivants qui sont immédiatement adjacents dans la table de vérité TV. Plus précisément, les sorties Q des bascules $51_1$ à $51_4$ ne peuvent alors basculer que vers, ou bien des états immédiatement adjacents supérieurs, ou bien des états immédiatement adjacents inférieurs dans la table de vérité TV. Ainsi, à titre d'exemple, les sorties Q des bascules $51_1$ et $51_4$ peuvent basculer des états "0" et "0", soit en les états "0" et "1", soit en les états "1" et "0". Il a été montré, en référence à la figure 6, qu'un signal RESET force, lors de l'initialisation du convertisseur, la sortie de la bascule RS 544 et donc le signal de commande CM à un état "1". Or il est possible que, suite à cette étape de réinitialisation, les états de sortie "naturels" initiaux des bascules $51_1$ et $51_4$ soient "0" et "0", ou "1" et "1" (table de vérité), et maintiennent ainsi le signal de commande CM à l'état "1". Mais il a été vu précédemment que la gigue de phase G des données entrantes DE peut provoquer un basculement d'états donnés des bascules $51_1$ et $51_4$ en des états immédiatement adjacents supérieurs ou inférieurs.

Ainsi, en référence à la table de vérité TV, les états "0" et "0", ou "1" et "1", mémorisés respectivement aux sorties des bascules $51_1$ et $51_4$ , et correspondant à un état "1" du signal de commande CM suite à la réinitialisation (RESET = "1") du convertisseur, peuvent basculer en les états "0" et "1". Le signal de commande CM prend alors l'état "0", en imposant un changement de phase du signal d'horloge sélectionné HS après la réinitialisation, changement de phase très néfaste au fonctionnement du convertisseur et pouvant entraîner des pertes de données. En supposant maintenant qu'immédiatement après l'initialisation du signal de commande CM à l'état "1" par le signal RESET, le signal de commande CM bascule à l'état "0" lors d'une augmentation de la gigue de phase G, alors le signal CM ne peut plus ensuite rebasculer à l'état "1", puisque comme signalé ci-dessus, compte tenu des conditions sur la gigue de phase G ($G<G_{max}$) et sur la durée d'analyse Ta, les états des sorties des bascules $51_1$ à $51_4$ ne peuvent basculer que d'états donnés à des états immédiatement adjacents, supérieurs ou inférieurs, en référence à la table de vérité TV, par excursion positive et négative de la gigue de phase.

Le problème de la gigue de phase ne se pose donc que si la sortie "naturelle" initiale de la bascule RS 544 produisant le signal de commande CM prend un état "1" identique à l'état auquel la bascule RS est initialement forcée lors de l'initialisation par le signal RESET. Plus précisément, ce problème de gigue de phase se pose si les sorties des bascules $51_1$ et $51_4$ prennent des états "1", "1" ou "0", "0" en maintenant le signal de commande CM à l'état "1". Dans ce cas en effet, la gigue de phase peut faire basculer les sorties des bascules $51_1$ à $51_4$ en des états immédiatement adjacents, soit "0" et "1" pour les bascules $51_1$ et $51_4$, entraînant un changement de phase du signal d'horloge sélectionné HS. Il faut noter cependant que, si la gigue du signal de données est inférieure à la gigue de phase maximale $G_{max}$, ce saut de phase ne se produira qu'une fois.

La figure 9 montre une seconde réalisation d'un circuit d'analyse de phase 5A inclus dans un convertisseur parallèle-série selon l'invention et résolvant ce problème de gigue de phase. Le circuit 5A comprend le circuit de mémorisation 51, le circuit d'échantillonnage 52, le circuit de retard 53 et le circuit de génération de signal de commande 54 identiques à et agencés de la même manière que ceux dans le circuit précédent 5 montré à la figure 6. Le circuit d'analyse de phase 5A comporte, en outre, un circuit d'initialisation de signal de commande 55. Ce circuit 55 comprend deux lignes à retard $551_1$ et $551_2$ connectées en cascade et imposant chacune un retard élémentaire Tr, un multiplexeur 4-vers-1 552, un compteur synchrone à 2 bits 553 constitué de deux bascules de type D $553_1$ et $553_2$, une porte NON-ET à deux entrées 554 et une porte ET à deux entrées 552.

Quatre entrées $E_O$, $E_1$, $E_2$, et $E_3$ du multiplexeur 552 reçoivent le signal relatif à l'un prédéterminé des fils du bus d'entrée de convertisseur, par exemple celui correspondant au signal de bit de poids faible $DE_O$ des mots de données à M bits parallèles DE, respectivement à travers la première ligne à retard $551_1$, à travers les deux lignes à retard $551_1$ et $551_2$, directement, et à travers la première ligne à retard $551_1$. Deux entrées d'adresse AD du multiplexeur 552 sont reliées à deux sorties respectives Q du compteur 553 et sélectionnent respectivement les entrées $E_O$, $E_1$, $E_2$ et $E_3$ lorsque AD="OO", "1O", "11" et "O1". Une sortie S du multiplexeur 552 est appliquée à l'entrée de la première ligne à retard $53_1$ dans le circuit de retard 53, à l'entrée d'horloge de la première bascule $52_1$ dans le circuit d'échantillonnage 52 et aux entrées d'horloge des bascules $51_1$ à $51_4$ dans le circuit de mémorisation 51, comme y est appliqué directement le signal de bit prédéterminé $DE_O$ dans le circuit 5 montré à la figure 6.

Les deux entrées de la porte 554 sont connectées respectivement à la sortie de données Q de la bascule $553_2$ et la sortie de données complémentaires $\overline{Q}$ de la bascule $553_1$. Ainsi la sortie de la porte NON-ET 554 est à l'état "0" pour des états "0" et "1" mémorisés aux sorties respectives Q des bascules $553_1$ et $553_2$ du compteur 553. La sortie de la porte 554 et le signal de bit prédéterminé $DE_O$ sont appliqués respectivement aux entrées de la porte ET 555. Le signal $DE_O$ n'est validé à la sortie de la porte 555 que pour des états respectifs mémorisés aux sorties Q des bascules $553_1$ et $553_2$ du compteur 553 différents de "0" et "1". Ce signal $DE_O$ est fourni aux entrées d'horloge des bascules $553_1$ et $553_2$. Dans le compteur synchrone 553, la sortie de données complémentaire $\overline{Q}$ de la seconde bascule $553_2$ est rebouclée sur l'entrée de données D de la première bascule $553_1$. Le signal de réinitialisation RESET appliqué à une entrée du circuit de génération de signal de commande 54, afin de forcer le signal de commande CM à l'état "1" lors d'une phase d'initialisation, et est également fourni à deux entrées de réinitialisation R des bascules $553_1$ et $553_2$ du compteur 553.

Comme évoqué précédemment, le circuit d'initialisation du signal de commande 55 est destiné à positionner le signal de commande CM à un état stable définitif lors de l'étape d'initialisation du convertisseur.

Lors de l'étape d'initialisation, le signal de réinitialisation RESET commande la mise à zéro, "0" et "0", des sorties Q du compteur 553. Trois fronts montants successifs du signal de bit prédéterminé $DE_O$ mettent respectivement les sorties Q des bascules $553_1$ et $553_2$ dans ce compteur aux états "1" et "0" puis, "1" et "1" puis "0" et "1". Ces deux derniers états "0" et "1" du compteur 553 ne sont alors plus modifiés puisque la sortie de la porte NON-ET 554 est à l'état "0" qui ne valident pas, à travers la porte fermée ET 555, le signal de bit prédéterminé $DE_O$.

Pour ces quatre couples d'états successifs aux sorties Q du compteur 553, les entrées $E_O$, $E_1$, $E_2$ et $E_3$ sont respectivement sélectionnées en sortie S du multiplexeur 552. Ainsi successivement, les signaux $DE_O$ respectivement retardé de Tr, puis retardé de 2Tr, puis non retardé et enfin à nouveau retardé de Tr sont sélectionnés en sortie S du multiplexeur 552.

Le retard Tr est sensiblement pris égal à la gigue maximale crête $G_{max}$ supportée par le convertisseur.

L'utilisation des deux lignes à retard $551_1$ et $551_2$ constitue un moyen d'étudier le comportement du convertisseur en présence de gigue de phase pour des excursions positive et négative maximales de cette gigue de phase autour d'une phase moyenne du signal de bit prédéterminé $DE_O$ déterminée par la phase du signal $DE_O$, alors retardé de Tr par la ligne à retard $551_1$.

Comme signalé précédemment dans la description, si la gigue de phase G est inférieure à la gigue de phase maximale $G_{max}$, alors lors de ces deux changements de phase par des excursions positive et négative de la gigue de phase, le signal de commande CM garde ou prend un état stable définitif et donc l'horloge sélectionnée HS ne subit par la suite aucun changement de phase.

En sachant que lors de l'initialisation, le signal RESET force le signal de commande CM à l'état "1", pour sélectionner ainsi le signal d'horloge $H_M'$, deux cas peuvent se produire lors de cette initialisation. Si lors des excursions positive et négative de la phase du signal de données d'entrée de part et d'autre d'une phase de signal $DE_O$ retardé de Tr, le signal de commande CM est maintenu à l'état "1", alors cet état est définitif. Si lors de ces excursions, le signal CM bascule à l'état "0", ce qui correspond à des états "1" et "1", ou "0" et "0", mémorisés aux sorties des bascules $51_1$ et $51_4$ respectivement suite à l'application du signal RESET et avant les excursions positive et négative de la gigue de phase du signal de bit prédéterminé $DE_O$, alors cet état "0" est définitivement maintenu pour le signal de commande CM, et le signal d'horloge $\overline{H_M}'$ est sélectionné pour cadencer le registre parallèle-parallèle 3. Il doit être noté que ce problème de gigue de phase ne se pose que lorsque le signal de commande CM prend un état "1" après le RESET, et que cet état "1" correspond à des sorties de bascules 511 et 514 respectivement à "O" et "O" ou "1" et "1".

Comme signalé précédemment, la gigue de phase maximale $G_{max}$ admissible par le convertisseur parallèle-série selon l'invention est directement fonction de la durée d'analyse Ta égale à la somme des trois retards Td imposés par les lignes à retard $53_1$ à $53_3$ du circuit de retard 53.

Selon une première variante, chacune de ces lignes à retard est réalisée par une chaîne d'inverseurs en cascade et en nombre pair. Chaque inverseur produit un retard fonction des dimensions des transistors qui le compose.

Selon une seconde variante montrée à la figure 1O, le circuit de retard 53 est constitué de plusieurs bascules de type D ,BA, connectées en cascade. L'entrée de données de la première bascule $BA_1$ reçoit le signal de bit prédéterminé $DE_O$ selon la figure 6, ou le signal en sortie S du multiplexeur 552 selon la figure 9. La sortie Q de chacune des autres bascules est reliée à l'entrée D de la bascule suivante respective. Chacune des lignes à retard $53_1$ à $53_3$ peut être constituée par une ou plusieurs bascules dont le nombre dépend de la durée d'analyse Ta et du nombre de bits M dans les mots de données DE, c'est-à-dire du rapport M entre la fréquence du signal d'horloge de bit H et de la fréquence des signaux d'horloge de mots $H_M$ et HS. Les entrées d'horloge des bascules BA reçoivent, alternativement une sur deux, respectivement le signal d'horloge de traitement série H et le signal complémentaire $\overline{H}$ de ce dernier. Ainsi chaque bascule induit un retard égal à une demi-période du signal d'horloge H.

A titre d'exemple, la figure 1O illustre un circuit de retard 53 composé de deux lignes à retard $53_1$ et $53_3$ imposant chacune un retard Td égal à une demi-période du signal d'horloge H, et comprenant chacune deux bascules $BA_1$ et $BA_2$, $BA_3$ et $BA_4$ afin de conférer une durée d'analyse de phase Ta égale à une période et demi du signal H.

**Revendications**

1. Convertisseur parallèle-série recevant d'un équipement de traitement numérique (EQ) des mots de données entrantes (DE) ayant chacun M bits parallèles ($DE_O$ à $DE_{M-1}$) pour les convertir en des bits sérialisés transmis à une première fréquence (F) dans un support de transmission (ST), ledit convertisseur comprenant

   une base de temps (1a), un registre parallèle-parallèle (3) et un registre parallèle-série (4),
   ladite base de temps (1a) recevant un signal d'horloge (H) à ladite première fréquence (F) et produisant un signal d'horloge de chargement (LOAD) à une seconde fréquence (F/M) M fois inférieure à ladite première fréquence (F) pour cadencer le chargement des mots de données à bits parallèles (DE) préalablement transférés à des sorties du registre parallèle-parallèle (3), dans le registre parallèle-série (4), et un premier signal d'horloge ($H_M$) à ladite seconde fréquence transmis audit équipement de traitement numérique pour synchroniser celui-ci,

      caractérisé en ce que

   ladite base de temps (1a) établit en outre deux seconds signaux d'horloge ($H_M'$, $\overline{H_M}'$) à ladite seconde fréquence et sensiblement en opposition de phase l'un par rapport à l'autre,
   et en ce que ledit convertisseur comprend en outre un moyen d'analyse de phase (5) pour analyser la phase desdits mots de données entrantes à bits parallèles (DE) relativement à la phase dudit premier signal d'horloge ($H_M$) afin de sélectionner l'un desdits deux seconds signaux d'horloge ($H_M'$, $\overline{H_M}'$) selon que lesdits mots de données et le premier signal d'horloge sont approximativement en phase et en opposition de phase respectivement, en un signal d'horloge sélectionné (HS) qui cadence le transfert des mots de données (DE) aux sorties dudit registre parallèle-parallèle (3).

**2.** Convertisseur parallèle-série conforme à la revendication 1, caractérisé en ce que ledit premier signal d'horloge ($H_M$) et l'un desdits deux seconds signaux d'horloge ($H_M'$, $\overline{H_M}'$) sont sensiblement déphasés l'un par rapport à l'autre.

**3.** Convertisseur parallèle-série conforme à la revendication 1 ou 2, caractérisé en ce que des instants de chargement dudit registre parallèle-série (4) déterminés par ledit signal d'horloge de chargement (LOAD) se produisent périodiquement sensiblement après des instants de transfert de mots de données entrantes déterminés par l'un quelconque desdits deux seconds signaux d'horloge ($H_M'$, $\overline{H_M}'$).

**4.** Convertisseur parallèle-série conforme à l'une quelconque des revendications 1 à 3, caractérisé en ce que la base de temps (1a) établit l'un desdits deux seconds signaux d'horloge ($H_M'$) directement, et l'autre ($\overline{H_M}'$) desdits deux seconds signaux d'horloge à travers un moyen inverseur logique (11a) recevant ledit un second signal d'horloge ($H_M'$).

**5.** Convertisseur parallèle-série conforme à l'une quelconque des revendications 1 à 4, caractérisé en ce que ledit moyen d'analyse de phase (5) comprend :

plusieurs moyens de retard ($53_1$, $53_2$, $53_3$) connectés en cascade, et imposant des retards dont la somme définit une durée d'analyse de phase prédéterminée (Ta), pour retarder l'un prédéterminé ($DE_O$) de M signaux de bit relatifs aux M bits parallèles dans lesdits mots de données entrantes (DE) en plusieurs signaux retardés, respectivement, ladite durée d'analyse (Ta) étant inférieure à une demi-période desdits signaux d'horloge ($H_M$, $H_M'$, $\overline{H_M}'$) à la seconde fréquence (F/M),
plusieurs moyens d'échantillonnage ($52_1$, $52_2$, $52_3$, $52_4$) pour échantillonner ledit premier signal d'horloge ($H_M$) en réponse à des transitions logiques prédéterminées ("O" vers "1") dudit signal de bit prédéterminé ($DE_O$) et desdits signaux retardés afin de produire respectivement plusieurs signaux d'échantillonnage (Q, 52) respectivement, et
un moyen logique (54) pour générer, en fonction de deux ($Q_1$, $Q_4$) desdits plusieurs signaux d'échantillonnage, un signal de commande (CM) dont les états logiques sélectionnent lesdits seconds signaux d'horloge ($H_M'$, $\overline{H_M}'$) respectivement.

**6.** Convertisseur parallèle-série conforme à la revendication 5, caractérisé en ce qu'il comprend un moyen de commutation (6) recevant par deux entrées respectives lesdits deux seconds signaux d'horloge ($H_M'$, $\overline{H_M}'$) et par une entrée de commande (EC) ledit signal de commande (CM) pour appliquer au registre parallèle-parallèle (3) l'un desdits deux seconds signaux d'horloge ($H_M'$, $\overline{H_M}'$) en tant que ledit signal d'horloge sélectionné (HS), en fonction de l'état logique du signal de commande.

**7.** Convertisseur parallèle-série conforme à la revendication 5 ou 6, caractérisé en ce que ledit moyen d'analyse de phase (5) comprend en outre
plusieurs moyens de mémorisation ($51_1$, $51_2$, $51_3$, $51_4$) connectés entre lesdits plusieurs moyens d'échantillonnage et ledit moyen logique pour mémoriser pendant une durée de transmission d'un mot de données entrantes à bits parallèles (DE), des états logiques desdits signaux d'état d'échantillonnage (Q, 52) produits respectivement par lesdits plusieurs moyens d'échantillonnage ($52_1$, $52_2$, $52_3$, $52_4$).

**8.** Convertisseur parallèle-série conforme à l'une quelconque des revendications 5 à 7, caractérisé en ce que

lesdits deux signaux d'échantillonnage ($Q_1$, $Q_4$) résultent de l'échantillonnage dudit premier signal d'horloge ($H_M$) par ledit signal de bit prédéterminé ($DE_O$) et le plus retardé desdits signaux retardés, et
ledit moyen logique (54) comprend un premier moyen d'entrée (542) sensible à l'un ($Q_1$) desdits deux signaux d'échantillonnage et à un signal inverse de l'autre ($Q_4$) desdits deux signaux d'échantillonnage afin que ledit moyen logique génère un premier état logique (CM="1") dudit signal de commande sélectionnant l'un ($H_M'$) desdits deux seconds signaux d'horloge, et un second moyen d'entrée (543) sensible audit autre ($Q_4$) desdits deux signaux d'échantillonnage et à un signal inverse dudit un ($Q_1$) desdits deux signaux d'échantillonnage afin que ledit moyen logique génère un second état logique (CM="O") dudit signal de commande sélectionnant l'autre ($\overline{H_M}'$) desdits deux seconds signaux d'horloge.

**9.** Convertisseur parallèle-série conforme à l'une quelconque des revendications 5 à 8, caractérisé en ce que

ledit moyen d'analyse de phase (5A) comprend en outre un moyen ($54_1$, RESET) pour forcer, lors d'une procédure initiale de fonctionnement dudit convertisseur parallèle-série, le signal de commande (CM) en un signal forcé à un état donné ("1") sélectionnant l'un ($\overline{H_M}'$) desdits deux seconds signaux d'horloge, et ledit signal de bit prédéterminé (DE$_O$) est reçu à travers un moyen d'initialisation de signal de commande (55) pour initialiser à un état stable définitif, lors de ladite procédure initiale, ledit signal de commande forcé indépendamment d'une quelconque gigue de phase dans les mots de données entrantes (DE) inférieure à une gigue de phase maximale (G$_{max}$).

10. Convertisseur parallèle-série conforme à la revendication 9, caractérisé en ce que la gigue de phase maximale (G$_{max}$) est sensiblement égale à la différence entre la demi-période desdits signaux d'horloge (H$_M$, H$_M$', $\overline{H_M}'$) à la seconde fréquence (F/M) et ladite durée d'analyse de phase (Ta).

11. Convertisseur parallèle-série conforme à la revendication 9 ou 10, caractérisé en ce que ledit moyen d'initialisation (55) comprend des premier et second moyens de retard connectés en cascade (551$_1$, 551$_2$) recevant ledit signal de bit prédéterminé (DE$_O$) pour produire respectivement des premier et second signaux retardés, et un moyen (552, 553) pour sélecter pendant ladite procédure initiale successivement le premier signal retardé par le premier moyen de retard (551$_1$), puis le second signal retardé par les premier et second moyens de retard (551$_1$, 551$_2$), puis ledit signal de bit prédéterminé, et enfin ledit premier signal retardé, chacun desdits premier et second moyens de retard imposant un retard (Tr) sensiblement égal à la gigue de phase maximale (G$_{max}$).

12. Convertisseur parallèle-série conforme à l'une quelconque des revendications 5 à 11, caractérisé en ce que chacun desdits plusieurs moyens de retard (53$_1$, 53$_2$, 53$_3$) est constitué d'au moins une bascule (BA), lesdites bascules (BA$_1$ - BA$_4$) étant connectées en cascade et ayant des entrées d'horloge recevant alternativement, une sur deux, ledit signal d'horloge (H) à ladite premier fréquence et un signal ($\overline{H}$) complémentaire de ce dernier.

## Patentansprüche

1. Parallel-Seriell-Umsetzer, der von einer digitalen Verarbeitungseinrichtung (EQ) eingehende Datenworte (DE) mit jeweils M parallelen Bits (DE$_0$ bis DE$_{M-1}$) empfängt, um sie in serielle und mit einer ersten Frequenz (F) in einem ersten Übertragungsträger (ST) übertragene Bits umzuwandeln, wobei dieser Umsetzer

   eine Zeitbasis (1a), ein Parallel-Parallel-Register (3) und ein Parallel-Seriell-Register (4) aufweist,

   wobei die Zeitbasis (1a) ein Zeitsignal (H) mit der ersten Frequenz (F) empfängt und ein Ladezeitsignal (LOAD) mit einer zweiten Frequenz (F/M) M-fach unterhalb der ersten Frequenz (F) für das Takten des Ladens der Datenworte mit parallelen Bits (DE), die zuvor zu Ausgängen des Parallel-Parallel-Registers (3) übertragen worden sind, in das Parallel-Seriell-Register (4), und ein erstes Zeitsignal (H$_M$) mit der zweiten Frequenz, das zur digitalen Verarbeitungseinrichtung zu ihrer Synchronisierung übertragen wird, erzeugt,

   dadurch gekennzeichnet, daß

   die Zeitbasis (1a) außerdem zwei Zeitsignale (H$_{M'}$, $\overline{H_{M'}}$) mit der zweiten Frequenz und mit entgegengesetzter Phase zueinander erzeugt,

   und daß der Umsetzer außerdem eine Phasenanalyseeinrichtung (5) für die Analyse der Phase der eingehenden Datenworte mit parallelen Bits (DE) bezüglich der Phase des ersten Zeitsignales (H$_M$), um eines der beiden zweiten Zeitsignale (H$_{M'}$, $\overline{H_{M'}}$), je nachdem die Datenworte und das erste Zeitsignal ungefähr in Phase oder in Gegenphase sind, als ein ausgewähltes Zeitsignal (HS) auszuwählen, das die Übertragung der Datenworte (DE) zu den Ausgängen des Parallel-Parallel-Registers (3) taktet.

2. Parallel-Seriell-Umsetzer nach Anspruch 1, dadurch gekennzeichnet, daß das erste Zeitsignal (H$_M$) und eines der zweiten Zeitsignale (H$_{M'}$, $\overline{H_{M'}}$) zueinander phasenverschoben sind.

3. Parallel-Seriell-Umsetzer nach Anspruch 1 oder 2, dadurch gekennzeichnet, daß Ladezeitpunkte des Parallel-Seriell-Registers (4), die vom Ladezeitsignal (LOAD) bestimmt werden, periodisch auf Übertragungszeitpunkte der eintreffenden Datenworte, die von einem der beiden zweiten Zeitsignale (H$_{M'}$, $\overline{H_{M'}}$) bestimmt werden, folgen.

4. Parallel-Seriell-Umsetzer nach einem der Ansprüche 1 bis 3, dadurch gekennzeichnet, daß die Zeitbasis (1a) eines

EP 0 580 234 B1

der beiden zweiten Zeitsignale ($H_{M'}$) direkt und das andere ($\overline{H_{M'}}$) der beiden zweiten Zeitsignale über eine logische Invertereinrichtung (11a), die ein zweites Zeitsignal ($H_{M'}$) empfängt, erzeugt.

5. Parallel-Seriell-Umsetzer nach einem der Ansprüche 1 bis 4, dadurch gekennzeichnet, daß die Phasenanalyse-einrichtungen (5)

mehrere Verzögerungseinrichtungen ($53_1$, $53_2$, $53_3$), die in Kaskade miteinander verbunden sind und Verzögerungen bewirken, deren Summe eine vorgegebene Dauer der Phasenanalyse (Ta) definiert, zur Verzöge-rung eines vorgegebenen ($DE_0$) von M Bitsignalen bezüglich M paralleler Bits in den eintreffenden Datenworten (DE) in mehrere verzögerte Signale, wobei die Analysedauer (Ta) kleiner als eine Halbperiode der Zeitsignale ($H_M$, $H_{M'}$, $\overline{H_{M'}}$) mit der zweiten Frequenz (F/M) ist,

mehrere Abtasteinrichtungen ($52_1$, $52_2$, $52_3$, $52_4$) zum Abtasten des ersten Zeitsignales ($H_M$) als Antwort auf vorgegebene logische Übergänge ("0" nach "1") des vorgegebenen Bitsignales ($DE_0$) und der verzögerten Signale, um jeweils mehrere Abtastsignale (Q, 52) zu erzeugen, und

eine logische Einrichtung (54) zur Erzeugung eines Steuersignales (CM) als Funktion von zwei ($Q_1$, $Q_4$) der mehreren Abtastsignale, dessen logische Zustände jeweils die zweiten Zeitsignale ($H_{M'}$, $\overline{H_{M'}}$) auswählen, aufweisen.

6. Parallel-Seriell-Umsetzer nach Anspruch 5, dadurch gekennzeichnet, daß er eine Schalteinrichtung (6) aufweist, die über zwei Eingänge die beiden zweiten Zeitsignale ($H_{M'}$, $\overline{H_{M'}}$) und über einen Steuereingang (EC) das Steuersignal (CM) empfängt, um auf das Parallel-Parallel-Register (3) eines der beiden zweiten Zeitsignale ($H_{M'}$, $\overline{H_{M'}}$) in der Eigenschaft als das ausgewählte Zeitsignal (HS) als Funktion des logischen Zustandes des Steuersignales zu geben.

7. Parallel-Seriell-Umsetzer nach Anspruch 5 oder 6, dadurch gekennzeichnet, daß die Phasenanalyseeinrichtung (5) außerdem aufweist:
mehrere Speichereinrichtungen ($51_1$, $51_2$, $51_3$, $51_4$), die zwischen den mehreren Abtasteinrichtungen und der logischen Einrichtung angeordnet sind, um während der Dauer der Übertragung eines eintreffenden Datenwortes mit parallelen Bits (DE) logische Zustände der Abtastsignale (Q, 52) abzuspeichern, die durch die mehreren Abt-asteinrichtungen ($52_1$, $52_2$, $52_3$, $52_4$) erzeugt wurden.

8. Parallel-Seriell-Umsetzer nach einem der Ansprüche 5 bis 7, dadurch gekennzeichnet, daß

die zwei Abtastsignale ($Q_1$, $Q_4$) aus dem Abtasten des ersten Zeitsignales ($H_M$) durch das vorgegebene Bit-signal ($DE_0$) und dem am stärksten verzögerten der verzögerten Signale entstehen und

die logische Einrichtung (54) eine erste Eingangseinrichtung (542) mit einem ($Q_1$) der beiden Abtastsignale und mit einem inversen zum anderen Signal ($Q_4$) der beiden Abtastsignale, damit die logische Einrichtung einen ersten logischen Zustand (CM="1") des Steuersignales erzeugt, das eines ($H_{M'}$) der beiden zweiten Zeitsignale auswählt, und eine zweite Eingangseinrichtung (543) mit dem anderen ($Q_4$) der beiden Abtastsi-gnale und mit einem inversen Signal zum ersten ($Q_1$) der beiden Abtastsignale, damit die logische Einrichtung einen zweiten logischen Zustand (CM="0") des Steuersignales erzeugt, das das andere ($\overline{H_{M'}}$) der beiden zweiten Zeitsignale auswählt, aufweist.

9. Parallel-Seriell-Umsetzer nach einem der Ansprüche 5 bis 8, dadurch gekennzeichnet, daß

die Phasenanalyseeinrichtung (5A) außerdem eine Einrichtung ($54_1$, RESET) aufweist, um während eines Betriebsstartverfahrens des Parallel-Seriell-Umsetzers das Steuersignal (CM) in ein Signal mit einem vorgegebenen Zustand ("1") zu zwingen, das eines ($\overline{H_{M'}}$) der beiden zweiten Zeitsignale auswählt, und

das vorgegebene Bitsignal ($DE_0$) über eine Initialisierungseinrichtung des Steuersignales (55) empfangen wird, um während des Startverfahrens das erzwungene Steuersignal mit einem stabilen definierten Zustand zu initialisieren, unabhängig von irgendeiner Phasenschwankung in den eintreffenden Datenworten (DE) un-terhalb einer maximalen Phasenschwankung ($G_{max}$).

10. Parallel-Seriell-Umsetzer nach Anspruch 9, dadurch gekennzeichnet, daß die maximale Phasenschwankung

($G_{max}$) gleich der Differenz zwischen der Halbperiode der Zeitsignale ($H_M$, $H_{M'}$, $\overline{H_{M'}}$) mit der zweiten Frequenz (F/M) und der Phasenanalysedauer (Ta) ist.

11. Parallel-Seriell-Umsetzer nach Anspruch 9 oder 10, dadurch gekennzeichnet, daß die Initialisierungseinrichtung (55) erste und zweite in Kaskade angeordnete Verzögerungseinrichtungen ($551_1$, $551_2$), die das vorgegebene Bitsignal ($DE_0$) empfangen, um jeweils erste und zweite verzögerte Signale zu erzeugen, und eine Einrichtung (552, 553) aufweist zur sukzessiven Auswahl des ersten verzögerten Signales während des Startverfahrens durch die erste Verzögerungseinrichtung ($551_1$), dann des zweiten, von den ersten und zweiten Verzögerungseinrichtungen ($551_1$, $551_2$) verzögerten Signales, dann des vorgegebenen Bitsignales und dann des ersten verzögerten Signales aufweist, wobei jedes der ersten und zweiten Verzögerungseinrichtungen eine Verzögerung (Tr) bewirkt, die gleich der maximalen Phasenschwankung ($G_{max}$) ist.

12. Parallel-Seriell-Umsetzer nach einem der Ansprüche 5 bis 11, dadurch gekennzeichnet, daß jede der mehreren Verzögerungseinrichtungen ($53_1$, $53_2$, $53_3$) von mindestens einer Kippschaltung (BA) gebildet wird, wobei die Kippschaltungen ($BA_1$ bis $BA_4$) in Kaskade angeordnet sind und Zeiteingänge aufweisen, die, abwechselnd einer von beiden, das Zeitsignal (H) mit der ersten Frequenz und ein dazu komplementäres Signal ($\overline{H}$) empfangen.

## Claims

1. Parallel-to-serial converter receiving incoming data words (DE) each having M parallel bits ($DE_0$ to $DE_{M-1}$) from a digital processing device (EQ) for converting them into serialized bits transmitted at a first frequency (F) in a transmission medium (ST), said converter comprising

   a time base (1a), a parallel-to-parallel register (3) and a parallel-to-serial register (4),
   said time base (1a) receiving a clock signal (H) at said first frequency (F) and producing a loading clock signal (LOAD) at a second frequency (F/M) M times less than said first frequency (F) to rhythm the loading of the data words with parallel bits (DE), which are previously transferred to outputs of the parallel-to-parallel register (3), into the parallel-to-serial register (4), and a first clock signal ($H_M$) at said second frequency transmitted to said digital processing device to synchronize it,

   characterized in that

   said time base (1a) further products two second clock signals ($H_{M'}$, $\overline{H_M}'$) at said second frequency and substantially in opposition of phase to each other,
   and that said converter further comprises a phase analysing means (5) for analysing the phase of said incoming data words with parallel bits (DE) compared to the phase of said first clock signal ($H_M$) in order to select one of said two second clock signals ($H_{M'}$, $\overline{H_M}'$) according to whether said data words and the first clock signal are approximately in phase and in opposition of phase, respectively, in a selected clock signal (HS) which rhythms the transfer of the data words (DE) to the outputs of said parallel-to-parallel register (3).

2. Parallel-to-serial converter according to claim 1, characterized in that said first clock signal ($H_M$) and one of said two second clock signals ($H_{M'}$, $\overline{H_M}'$) are substantially phase shifted with each other.

3. Parallel-to-serial converter according to claim 1 or 2, characterized in that loading times of said parallel-to-serial register (4) determined by the loading clock signal (LOAD) occur periodically substantially after transfer times of the incoming data words determined by any one of said two second clock signals ($H_{M\cdot}$, $\overline{H_M}'$).

4. Parallel-to-serial converter according to any one of claims 1 to 3, characterized in that the time base (1a) produces one of said two second clock signals ($H_{M'}$) directly, and the other ($\overline{H_M}'$) of said two second clock signals through a logic inverter means (11a) receiving said one second clock signal ($H_{M'}$).

5. Parallel-to-serial converter according to any one of claims 1 to 4, characterized in that said phase analysing means (5) comprises:

   several cascade-connected delay means ($53_1$, $53_2$, $53_3$) imposing delays the sum of which defines a predetermined phase analysis duration (Ta), for delaying predetermined one ($DE_0$) of M bit signals relative to the M parallel bits in said incoming data words (DE) in several delayed signals, respectively, said analysis duration (Ta) being less than a half-period of said clock signals ($H_M$, $H_{M'}$, $\overline{H_M}'$) at the second frequency (F/M), several sampling means ($52_1$, $52_2$, $52_3$, $52_4$) for sampling said first clock signal ($H_M$) in response to predetermined logic transitions ("0" to "1") of said predetermined bit signal ($DE_0$) and said delayed signals in order to produce several sampling signals (Q, 52) respectively, and

a logic means (54) for generating as a function of two (Q1, Q4) of said several sampling signals, a control signal (CM) whose two logic states select said two second clock signals ($H_{M'}$, $\overline{H_M}'$) respectively.

6. Parallel-to-serial converter according to claim 5, characterized in that it comprises a switching means (6) receiving said second clock signals ($H_{M'}$, $\overline{H_M}'$) through two respective inputs and said control signal (CM) through a control input (EC) for applying one of said two second clock signals ($H_{M'}$, $\overline{H_M}'$) to the parallel-to-parallel register (3) as a function of the logic state of the control signal, into said selected clock signal (HS).

7. Parallel-to-serial converter according to claim 5 or 6, characterized in that said phase analysing means (5) further comprises

several storing means ($51_1$, $51_2$, $51_3$, $51_4$) connected between said several sampling means and said logic means for storing logic states of said sampling state signals (Q, 52) produced respectively by said several sampling means ($52_1$, $52_2$, $52_3$, $52_4$) for a duration of transmission of one incoming data word with parallel bits (DE).

8. Parallel-to-serial converter according to any one of claims 5 to 7, characterized in that

said two sampling signals (Q1, Q4) result from sampling of said first clock signal ($H_M$) by said predetermined bit signal ($DE_0$) and a most delayed of said several delayed signals, and

said logic means (54) comprises a first input means (542) responsive to one (Q1) of said two sampling signals and to a signal inverted with respect to the other (Q4) of said two sampling signals so that the logic means generates an initial logic state (CM = "1") of said control signal selecting one ($H_{M'}$) of said two second clock signals, and a second input means (543) responsive to said other (Q4) of said two sampling signals and to a signal inverted with respect to said one (Q1) of said two sampling signals so that said logic means generates a second logic state (CM = "0") of said control signal selecting the other ($\overline{H_M}'$) of said two second clock signals.

9. Parallel-to-serial converter according to any one of claim 5 to 8, characterized in that

said phase analysing means (5A) further comprises a means ($54_1$, RESET) for forcing the control signal (CM) into a forced signal at a given state ("1") selecting one ($\overline{H_M}'$) of said two second clock signals during an initial operating stage of said parallel-to-serial converter, and

said predetermined bit signal ($DE_0$) is received through a control signal initiating means (55) to initiate to a stable definitive state during said initial stage, said forced control signal independently of any phase jitter in the incoming data words (DE) less than a maximal phase jitter ($G_{max}$).

10. Parallel-to-serial converter according to claim 9, characterized in that the maximal phase jitter ($G_{max}$) is substantially equal to the difference between the half-period of said clock signals ($H_M$, $H_{M'}$, $\overline{H_M}'$) at the second frequency (F/M) and said phase analysis duration (Ta).

11. Parallel-to-serial converter according to claim 9 or 10, characterized in that said initiating means (55) comprises first and second delay means connected in cascade ($551_1$, $551_2$) receiving said predetermined bit signal ($DE_0$) to produce first and second delayed signals, respectively, and a means (552, 553) for selecting during said initial stage, successively the first delayed signal by the first delay means ($551_1$), then the second delayed signal by the first and second delay means ($551_1$, $551_2$), then said predetermined bit signal, and finally said first delayed signal, each of said first and second delay means imposing a delay (Tr) substantially equal to the maximal phase jitter ($G_{max}$).

12. Parallel-to-serial converter according to any one of claims 5 to 11, characterized in that each of said several cascade-connected delay means ($53_1$, $53_2$, $53_3$) comprises at least one flip-flop (BA), said flip-flops ($BA_1$ - $BA_4$) being connected in cascade and having clock inputs receiving alternately, one out of two, said clock signal (H) at the first frequency and a signal ($\overline{H}$) complementary to the latter.

## *FIG.1*

(TECHNIQUE ANTERIEURE)

## *FIG.2*

(TECHNIQUE ANTERIEURE)

# FIG.3

# FIG.4

# FIG.5

# FIG.7

# FIG.6

CIRCUIT DE MEMORISATION

"RESET"

$51_1$ $51_2$ $51_3$ $51_4$

bascule RS
EM
541 544

542

543

545

EE

CIRCUIT DE GENERATION
DE SIGNAL DE COMMANDE

54

CM

$II_M$

$52_1$ $52_2$ $52_3$ $52_4$

CIRCUIT
D'ECHANTILLONNAGE

52

$BS_1$

M

$BS_0$

Td Td Td

$53_1$ $53_2$ $53_3$ 53

CIRCUIT DE RETARD

CIRCUIT D'ANALYSE DE PHASE 5

EP 0 580 234 B1

# FIG.8

INTRODUCTION DE LA
GIGUE DE PHASE

# FIG.10

*FIG.9*

CIRCUIT D'ANALYSE DE PHASE 5

"RESET"

CIRCUIT DE MEMORISATION

CIRCUIT DE GENERATION DE SIGNAL DE COMMANDE

CIRCUIT D'ECHANTILLONNAGE

CIRCUIT DE RETARD

COMPTEUR

CIRCUIT D'INITIALISATION DE SIGNAL DE COMMANDE

bascule RS

MUX

COMPTEUR

EP 0 580 234 B1